# EUROPEAN PATENT SPECIFICATION

(11) **EP 0 291 335 B1**
(45) Date of publication and mention of the grant of the patent: **27.07.1994**
(21) Application number: 88304367.1
(22) Date of filing: 13.05.1988
(51) Int. Cl.: H03K 5/15

(54) **Generating clock pulses**
Erzeugung von Taktimpulsen
Génération de signaux d'horloge

(30) Priority: 14.05.1987 JP 117508/87
(43) Date of publication of application: 17.11.1988
(73) Proprietor: SONY CORPORATION, Tokyo 141 (JP)
(72) Inventor: Watanabe, Nobuhisa, Shinagawa-ku Tokyo 141 (JP)
(74) Representative: Pilch, Adam John Michael

(56) References cited:
- EP-A- 0 190 554
- EP-A- 0 242 010
- PATENT ABSTRACTS OF JAPAN, vol. 10, no. 133 (E-404)[2190], 17th May 1986; & JP-A-60 263 523 (MITSUBISHI DENKI K.K.) 27-12-1985
- PATENT ABSTRACTS OF JAPAN, vol. 9, no. 137 (P-363)[1860], 12th June 1985; & JP-A-60 19 222 (NIPPON DENKI K.K.) 31-01-1985
- NEW ELECTRONICS, vol. 17, no. 14, 10th July 1984, pages 29,31-32, Warley, West Midlands, GB; G. JONES: "Designing with the 80C88 - A fully static CMOS processor"
- Integrierte D.Bausteine, E.Gelder, Vogel-Buchverlag Würzburg 1984
- The TTL DATA BOOK, Texas Instruments, 1973 page 121

## Description

This invention relates to generating clock pulses and in particular to one chip microprocessor clock pulse generators and to methods of producing clock pulses in microprocessors.

Silicon chip microprocessors including a central processing unit (CPU), a read only memory (ROM), a random access memory (RAM) and an input/output interface (I/O) are generally formed on a single chip so as to provide a one chip microcomputer, and are arranged to operate on a 5V power supply. However, there has recently arisen a demand for a one chip microprocessor which can be operated using batteries. Typically, this may mean that the supply from which the device is to be operated should be reduced from 5V to 3V. This voltage reduction causes a change in the generation of clock pulses which are used in connection with the operation of the CPU. When this change happens, however, improper operation may occur.

Accordingly, it is required to be able to produce low speed clock pulses when this reduction in power supply voltage occurs in a manner which renders it possible to maintain proper operation. It is additionally required to be able to provide low speed clock signals when the power supply voltage is reduced for the purposes of conserving electrical power and/or in the event of a power blackout.

Patent Abstracts of Japan, Vol. 9, No. 137 (p. 363) [1860], June 12, 1985, describes a clock generating circuit that operates a clock for a microcomputer by selecting a signal from a clock signal having plural frequencies according to a digital signal derived from the value of a power supply voltage applied to an input terminal.

Moreover, it is desirable to be able to expand control over the reading and writing cycles when accessing an external low speed expansion memory.

In order to achieve the above it has been proposed to use two clock pulse generators; one for high speed pulse signals and one for low speed pulse signals. However, this arrangement is such that when one is in use the other is rendered redundant. Further, when switching from one to the other, asynchronism or misalignment may occur in the positional relationship between the pulses.

The article "Designing with the 8OC88 - A Fully Static CMOS Processor" (New Electronics Vol 17 (1984) July, No. 14) discloses a circuit arrangement in which a microprocessor clocking signal may be electronically switched between a "normal" speed clock and a "slow" clock speed.

According to one aspect of the present invention there is provided a one chip microprocessor clock pulse generator comprising a source of clock pulses, means for successively dividing said clock pulses by the same ratio and producing a plurality of clock pulse signals, the pulse widths of which are different, said plurality of clock pulse signals being divided in a manner such that one of the leading and trailing edges of the pulses of said plurality of clock pulse signals occur coincidentally and thus enable switching from one to another of the signals without phase differences occurring, a plurality of gate circuits arranged selectively to supply one of the clock pulse signals to an output terminal arrangement, a discriminator input terminal connected to the plurality of gate circuits and responsive to a control signal from a memory address decoder to allow automatic switching of clock pulse signals at the output terminal arrangement from a high speed pulse signal processing cycle to a low speed external memory pulse signal access cycle, and automatically to resume the high speed pulse signal processing cycle upon termination of the control signal, and control means for controlling the gate circuits to switch from one to another of the clock pulse signals only when said one of the leading and trailing edges of the pulses of the clock pulse signals coincide.

A preferred embodiment of the present invention, to be described in greater detail hereafter, provides a clock pulse generator of simple construction and low cost which enables switching between high and low speed pulses without undesirable interruption of CPU activity.

In order to permit a one-chip type microprocessor to be operated from two different power sources such as a household supply and batteries and in order to facilitate slow speed external memory access, the output of a single source of pulses is sequentially frequency divided and gate circuits are arranged so that one of the plurality of divisions can be selectively supplied to an output terminal of the device.

The dividing means preferably comprises a plurality of frequency dividers connected in a manner wherein a first frequency divider is arranged to divide the pulses supplied from the source in a predetermined manner, and the next frequency divider is arranged to receive the output of the first frequency divider and perform substantially the same division.

Preferably, the plurality of clock pulse signals are divided in a manner such that one of the leading and trailing edges of the pulses occur coincidently and thus enable switching from one to the other without phase differences occurring.

According to another aspect of the present invention there is provided a method of producing clock pulse signals in a microprocessor and switching between the signals, the method comprising the steps of:
using a single source to produce a basic clock pulse signal;
successively dividing the basic clock pulse signal to form a series of pulse signals each having successively longer pulse widths, wherein one of the leading and trailing edges of said series of pulses signals are arranged to occur synchronously;
selectively using one of said series of pulse signals in connection with the control of said microprocessor, and producing automatic switching from a high speed pulse signal processing cycle to a low speed external memory pulse signal access cycle in response to a control signal from a memory address decoder to a discriminator input terminal, with automatic resumption of the high speed pulse signal processing cycle upon termination of the control signal; and controlling switching from one to another of the clock pulse signals to take place only when said one of the leading and trailing edges of the pulses of the clock pulse signals coincide.

Preferably, one of the leading and trailing edges of the series of pulse signals is arranged to occur synchronously.

The invention will now be described by way of example with reference to the accompanying drawings, in which:
Figure 1 is a circuit diagram showing the construction of a clock pulse generator according to an embodiment of the present invention; and
Figure 2 is a timing chart which demonstrates the operational characteristics of the arrangement shown in Figure 1.

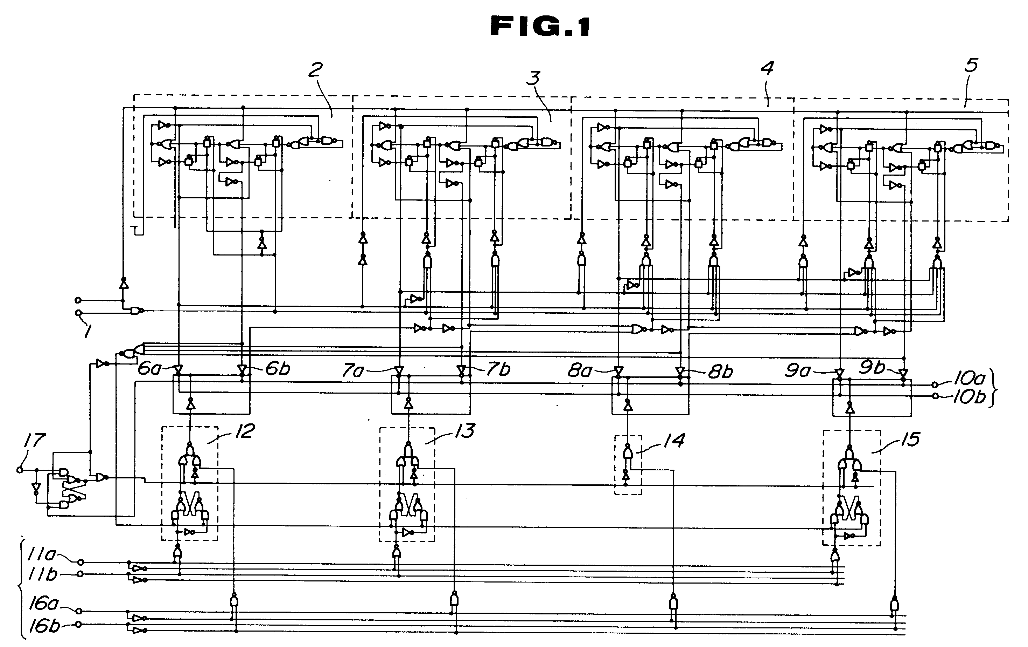

Figure 1 shows a circuit arrangement embodying the present invention and including input terminals 1 which are arranged to receive clock pulses, for example from a crystal type clock pulse generator (not shown), frequency dividers 2 to 5, gate circuits 6a, 6b, 7a, 7b, 8a, 8b, 9a, 9b, clock pulse output terminals 10a, 10b, gate control signal generator circuits 12 to 15, designated signal input terminals 11a, 11b, 16a, 16b, and a discrimination signal input terminal 17 which is arranged to receive a signal from a memory address decoder (not shown), all connected as shown.

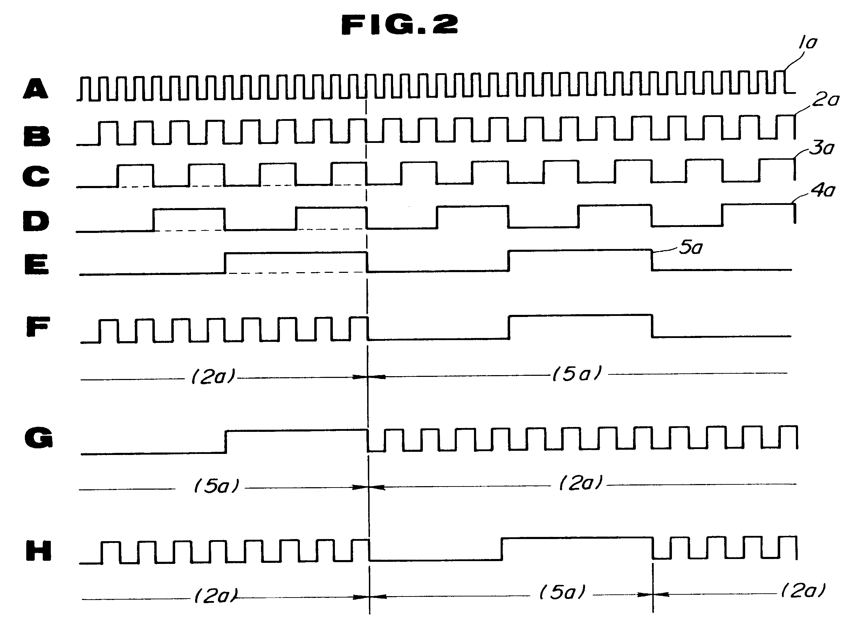

With this arrangement, the first frequency divider 2 is arranged to perform a first division (1/2) and divide input pulses 1a, shown in Figure 2A, in a manner to produce a pulse train 2a, as shown in Figure 2B. The second frequency divider 3 is arranged to perform a second division and to produce a pulse train having a frequency which is 1/4 that of the original input signal 1a, so as to produce a signal 3a as shown in Figure 2C.

The third and fourth frequency dividers 4, 5 are arranged to perform subsequent frequency divisions and to produce signals 4a and 5a (see Figures 2D and 2E) which respectively have frequencies which are 1/8 and 1/16 of the input signal 1a. As can be seen in Figure 2, each of the respective series of clock pulses are arranged to be formed with a 90^{o} phase difference.

The outputs of the frequency dividers 2 to 5 are respectively supplied, through the gate circuits 6a to 9b, to the clock signal output terminals 10a, 10b.

A two-bit digital signal from the computer control circuit is supplied to the designated signal input terminals 11a, 11b. This signal functions to selectively control the gate circuits 6a to 9b in such a way that, when both of the signals appearing on the terminals 11a and 11b assume a low level '0', the gate circuit 6a, 6b is switched to assume an ON state whereby the clock pulses 2a which have been divided by two (1/2) appear at the clock pulse output terminals 10a, 10b. den the terminals 11a and 11b assume low and high levels (0, 1) respectively, the gate circuit 7a, 7b is selectively conditioned to assume an ON state. Under these conditions, the clock pulse train 3a (divided by four) is supplied to the clock pulse output terminals 10a, 10b.

In the event that the signals appearing at the terminals 11a and 11b assume the respective levels 1 and 0, the gate circuit 8a, 8b assumes an ON state and the clock pulses 4a (divided by eight) are selectively applied to the output terminals 10a, 10b. Finally, if the signals appearing at the terminals 11a and 11b both assume high levels (1, 1), then the last of the gate circuits 9a, 9b assumes an ON state and applies the (1/16) divided pulse train 4a to the output terminals 10a, 10b.

When a two-bit signal from an external memory is applied to the terminals 16a and 16b, the gate control circuits 12 to 15 may be controlled selectively to open the gate circuits 6a to 9b in a similar manner.

In the case that the external memory is selected and a discrimination signal is applied to the terminal 17 therefrom, the gate control circuits 12 to 15 are selectively conditionable to open the gate circuits 6a to 9b.

When the circuit arrangement is put into operation in a manner wherein the high speed clock pulses 2a are to be changed to the pulses 5a shown in Figure 2E, low level signals are applied to both the terminals 11a and 11b. This induces the gate control circuit 12 to apply a high level signal (1) and condition the gate circuit 6a, 6b to assume an ON state. Under these conditions, high speed pulses 2a are applied to the output terminals 10a, 10b in the manner illustrated in Figure 2F and thence to the CPU of the microprocessor.

In the event that the control circuit of the microprocessor applies high level signals (1, 1) to both of the terminals 11a and 11b, the gate control circuit 15 is conditioned to apply a high level signal to the gate circuit 9a, 9b and thus open the gate circuit. This results in the pulses appearing at the clock pulse output terminals 10a, 10b assuming the form 5a shown in the latter half of Figure 2F.

As both of these signals 2a, 5a have been derived from the same basic signal 1a when the change occurs, the trailing edges of the two signals are aligned at the moment of switching, and no shift in signal timing can occur and thereby disturb the operation of the microprocessor.

In the case that the reverse change is to be induced and low speed clock pulses are to be changed to high speed pulses, the levels of the signals applied to the terminals 11a and 11b are switched from 1, 1 to 0, 0, respectively. At this time, the gate circuit 9a, 9b is rendered non-conductive while the gate circuit 6a, 6b is opened. the result of this is shown in Figure 2G. As will be noted, since the CPU is responsive to the clock pulses, the switching will be timed in accordance with the currently-supplied pulse train and thus, in this instance, will await a trailing edge of the low speed pulses before inducing the signal level change which will induce the supply of high speed pulses. As before, since the trailing edges of the pulses 2a and 5a are inherently aligned, the phasing of the two signals will be perfectly matched upon switching, thereby ensuring error-free CPU operation.

In the case that a low speed external memory access cycle is to be induced, a high level signal applied from a memory address decoder (not shown) is applied to the terminal 17. Prior to this time, the program being run in the CPU is controlled in accordance with the high speed pulses 2a. However, upon the application of the high level signal to the terminal 17, the gate circuit 6a, 6b is closed and the gate circuit 9a, 9b rendered conductive. Under these circumstances, the clock pulses being supplied change in the manner illustrated in Figure 2H and low speed clock pulses 5a are then fed to the CPU.

The high level signal applied to the terminal 17 is maintained for one memory cycle and is then automatically switched to the low level. This switching permits the resumption of the supply of the high speed clock pulses 2a to the CPU to permit appropriate processing, as shown in the final part of Figure 2H.

In accordance with the above-described arrangement, it is possible selectively to supply four different clock pulses simply by changing a two-bit signal. Accordingly, when the device is required to be operated from a low voltage source such as torch batteries or the like, it is possible to change the pulses 2a to the pulses 5a. It is also possible to switch to the low speed pulses 5a in the event of a blackout without adverse effect on the operation of the processor. Further, low speed external memory access bus cycle control is possible with the same simple hardware. Moreover, in the event that a system includes a high speed memory in addition to the above-mentioned low speed type, the appropriate clock signal control can be effected without the need for additional circuitry, and this increases the system throughput.

## Claims

1. A one chip microprocessor clock pulse generator comprising a source of clock pulses (1a), means (2 to 5) for successively dividing said clock pulses (1a) by the same ratio and producing a plurality of clock pulse signals (2a to 5a), the pulse widths of which are different, said plurality of clock pulse signals (2a to 5a) being divided in a manner such that one of the leading and trailing edges of the pulses of said plurality of clock pulse signals (2a to 5a) occur coincidentally and thus enable switching from one to another of the signals without phase differences occurring, a plurality of gate circuits (6a to 9b) arranged selectively to supply one of the clock pulse signals (2a to 5a) to an output terminal arrangement (10a, 10b), a discriminator input terminal (17) connected to the plurality of gate circuits (6a to 9b) and responsive to a control signal from a memory address decoder to allow automatic switching of clock pulse signals (2a to 5a) at the output terminal arrangement (10a, 10b) from a high speed pulse signal processing cycle (2a) to a low speed external memory pulse signal access cycle (5a), and automatically to resume the high speed pulse signal processing cycle (2a) upon termination of the control signal, and control means for controlling the gate circuits to switch from one to another of the clock pulse signals (2a to 5a) only when said one of the leading and trailing edges of the pulses of the clock pulse signals (2a to 5a) coincide.

2. A clock pulse generator according to claim 1, wherein said dividing means comprises a plurality of frequency dividers (2 to 5) connected in a manner wherein a first frequency divider (2) is arranged to divide the pulses (1a) supplied from said source in a predetermined manner, and the next frequency divider (3) is arranged to receive the output of the first frequency divider (2) and perform substantially the same division.

3. A clock pulse generator according to claim 1 or claim 2, including first and second sets of input terminals (11a, 11b; 16a, 16b) via which two-bit control signals can be supplied in a manner which permits selective control of said gate circuits (6a to 9b).

4. A method of producing clock pulse signals in a microprocessor and switching between the signals, the method comprising the steps of:
using a single source to produce a basic clock pulse signal (1a);
successively dividing (2 to 5) the basic clock pulse signal (1a) to form a series of pulse signals (2a to 5a) each having successively longer pulse widths, wherein one of the leading and trailing edges of said series of pulses signals (2a to 5a) are arranged to occur synchronously;
selectively using (6a to 9b) one of said series of pulse signals (2a to 5a) in connection with the control of said microprocessor, and producing automatic switching from a high speed pulse signal processing cycle (2a) to a low speed external memory pulse signal access cycle (5a) in response to a control signal from a memory address decoder to a discriminator input terminal (17), with automatic resumption of the high speed pulse signal processing cycle (2a) upon termination of the control signal; and
controlling switching from one to another of the clock pulse signals (2a to 5a) to take place only when said one of the leading and trailing edges of the pulses of the clock pulse signals (2a to 5a) coincide.

## Patentansprüche

1. Einchip-Mikroprozessor-Taktimpulsgenerator mit einer Quelle von Taktimpulsen (1a), Mitteln (2 bis 5) zur aufeinanderfolgenden Teilung der Taktimpulse (1a) im gleichen Verhältnis und zur Erzeugung einer Anzahl von Taktimpulssignalen (2a bis 5a), deren Impulsbreiten verschieden sind, wobei die Anzahl der Taktimpulssignale (2a bis 5a) in einer Weise so geteilt ist, daß eine von den Anstiegs- und Abfallflanken der Impulse der Anzahl der Taktimpulssignale (2a bis 5a) gleichzeitig auftreten und somit ein Schalten vom einem zum anderen Signal ermöglicht wird, ohne daß Phasendifferenzen auftreten, mehreren Gatterschaltungen (6a bis 9b), die selektiv angeordnet sind, um eines der Taktimpulssignale (2a bis 5a) zu einer Ausgangssignalanschlußeinrichtung (10a, 10b) zu liefern, einem Diskriminatoreingangssignalanschluß (17), der mit der Anzahl der Gatterschaltungen (6a bis 9b) verbunden ist und der in Abhängigkeit von einem Steuersignal von einem Speicheradreßdecoder ein automatisches Schalten der Taktimpulssignale (2a bis 5a) bei der Ausgangssignalanschlußeinrichtung (10a, 10b) von einem Hochgeschwindigkeits-Impulssignalverarbeitungszyklus (2a) in einen externen langsamen Speicher-Impulssignal-Zugriffszyklus (5a) erlaubt, und der automatisch den Hochgeschwindigkeits-Impulssignalverarbeitungzyklus (2a) bei einer Beendigung des Steuersignals wieder aufnimmt, und Steuermitteln zum Steuern der Gatterschaltungen, um von einem zum anderen der Taktimpulssignale (2a bis 5a) nur umzuschalten, wenn eine von den Anstiegs- und Abfallflanken der Impulse der Taktimpulssignale (2a bis 5a) zusammenfallen.

2. Taktimpulsgenerator nach Anspruch 1, wobei die Teilungsmittel mehrere Frequenzteiler (2 bis 5) aufweisen, die in einer Weise verbunden sind, daß der erste Frequenzteiler (2) so angeordnet ist, daß er die Impulse (1a) teilt, die von der Quelle in einer vorgegebenen Weise geliefert werden, und daß der nächste Frequenzteiler (3) so angeordnet ist, daß er das Ausgangssignal des ersten Frequenzteilers (2) empfängt und im wesentlichen die gleiche Teilung durchführt.

3. Taktimpulsgenerator nach Anspruch 1 oder 2, der erste und zweite Sätze von Eingangssignalanschlüssen (11a, 11b; 16a, 16b) aufweist, über die Zweibit-Steuersignale in einer Weise geliefert werden können, daß eine selektive Steuerung der Gatterschaltungen (6a bis 9b) ermöglicht wird.

4. Verfahren zur Erzeugung von Taktimpulssignalen in einem Mikroprozessor und Schalten zwischen den Signalen, wobei das Verfahren die folgenden Schritte aufweist:
Verwendung einer Einzelquelle zur Erzeugung eines Basistaktimpulssignals (1a);
aufeinanderfolgendes Teilen (2 bis 5) des Basistaktimpulssignals (1a), um eine Serie von Impulssignalen (2a bis 5a) zu bilden, die jeweils aufeinanderfolgend längere Impulsbreiten haben, wobei eine der Anstiegs- und Abfallflanken der Serien der Impulssignale (2a bis 5a) so angeordnet ist, daß sie synchron auftreten;
selektives Verwenden (6a bis 9b) einer der Serien der Impulssignale (2a bis 5a) in Verbindung mit der Steuerung des Mikroprozessors, und Erzeugen einer automatischen Schaltung von einem Hochgeschwindigkeits-Impulssignalverarbeitungszyklus (2a) in einen externen langsamen Speicher-Impulssignal-Zugriffszyklus (5a) in Abhängigkeit von einem Steuersignal von einem Speicheradreßdecoder zu einem Diskriminatoreingangssignalanschluß (17), wobei der Hochgeschwindigkeits-Impulssignalverarbeitungszyklus (2a) bei Beendigung des Steuersignals automatisch wiederaufgenommen wird; und
Steuern des Schaltens von einem zum anderen der Taktimpulssignale (2a bis 5a), das nur stattfinden soll, wenn die eine der Anstiegs- und Abfallflanken der Impulse der Taktimpulssignale (2a bis 5a) zusammenfallen.

## Revendications

1. Générateur d'impulsions d'horloge pour un microprocesseur monolithique comprenant une source d'impulsions d'horloge (1a), un dispositif (2 à 5) pour diviser successivement lesdites impulsions d'horloge (1a) par le même rapport et produire une pluralité d'impulsions d'horloge (2a à 5a), dont les largeurs d'impulsions sont différentes, ladite pluralité de signaux d'impulsions d'horloge (2a à 5a) étant divisées d'une manière telle qu'un des flancs avant et arrière des impulsions de ladite pluralité de signaux d'impulsions d'horloge (2a à 5a) se produisent de façon coïncidente et permettent donc la commutation de l'un à l'autre des signaux sans qu'il se produise de déphasage, une pluralité de circuits de porte (6a à 9b) disposés sélectivement pour fournir un des signaux d'impulsions d'horloge (2a à 5a) à une disposition de bornes de sortie (10a, 10b), une borne d'entrée du discriminateur (17) relié à la pluralité de circuits de porte (6a à 9b) et sensible à un signal de commande d'un décodeur d'adresse de mémoire pour permettre une commutation automatique des signaux d'impulsions d'horloge (2a à 5a) sur la disposition de borne de sortie (10a, 10b) à partir d'un cycle de traitement du signal d'impulsions à vitesse élevée (2a) jusqu'à un cycle d'accès du signal d'impulsions de mémoire externe de vitesse lente (5a), et pour reprendre automatiquement le cycle de traitement du signal d'impulsions à vitesse élevée (2a) lors de la cessation du signal de commande, et un dispositif de commande pour commander les circuits de porte pour commuter de l'un à l'autre des signaux d'impulsions d'horloge (2a à 5a) seulement lorsqu'un desdits flancs avant et arrière des impulsions des signaux d'impulsions d'horloge (2a à 5a) coïncident.

2. Générateur d'impulsions d'horloge selon la revendication 1, dans lequel ledit dispositif de division comprend une pluralité de diviseurs de fréquence (2 à 5) reliés de manière à ce qu'un premier diviseur de fréquence (2) soit disposé pour diviser les impulsions (1a) fournies par ladite source d'une manière prédéterminée, et le diviseur de fréquence suivant (3) est disposé pour recevoir la sortie du premier diviseur de fréquence (2) et pour réaliser essentiellement la même division.

3. Générateur d'impulsions d'horloge selon la revendication 1 ou la revendication 2, comprenant des premier et second jeux de bornes d'entrée (11a, 11b; 16a, 16b) via lesquels des signaux de commande à deux bits peuvent être appliqués d'une manière qui permet la commande sélective desdits circuits de porte (6a à 9b).

4. Procédé pour produire des signaux d'impulsions d'horloge dans un microprocesseur et pour commuter entre les signaux, le procédé comprenant les étapes de :
utilisation d'une source unique pour produire un signal d'impulsions d'horloge de base (1a);
division successive (2 à 5) du signal d'impulsions d'horloge de base (1a) pour former une série de signaux d'impulsions (2a à 5a) ayant chacune successivement des largeurs d'impulsions plus longues, dans lequel un des flancs avant et arrière desdites séries de signaux d'impulsions (2a à 5a) sont disposés pour se produire de façon synchrone;
utilisation sélective (6a à 9b) d'une desdites séries des signaux d'impulsions (2a à 5a) en liaison avec la commande dudit microprocesseur, et
production d'une commutation automatique à partir d'un cycle de traitement du signal d'impulsions de vitesse élevée (2a) d'un cycle d'accès du signal d'impulsions de mémoire externe de vitesse lente (5a) en réponse à un signal de commande à partir d'un décodeur d'adresse de mémoire jusqu'à une borne d'entée du discriminateur 17, avec une reprise automatique du cycle de traitement du signal d'impulsions à vitesse élevée (2a) lors de la cessation du signal de commande ; et
commande commutation de l'un à l'autre des signaux d'impulsions d'horloge (2a à 5a) pour avoir lieu seulement lorsqu'un des flancs avant et arrière des impulsions des signaux d'impulsions d'horloge (2a à 5a) coïncident.
